# EUROPEAN PATENT APPLICATION

(11) **EP 0 752 717 A1**
(43) Date of publication of application: **08.01.1997**
(21) Application number: 95830189.7
(22) Date of filing: 10.05.1995
(51) Int. Cl.: H01L 21/00, H01L 21/8247, H01L 21/8242, H01L 27/105

(54) **A method of manufacturing a MOS integrated circuit having components with different dielectrics**

(71) Applicant: SGS-THOMSON MICROELECTRONICS S.r.l., 20041 Agrate Brianza (Milano) (IT)
(72) Inventor: Ghidini, Gabriella, I-20131 Milano (IT); Clementi, Cesare, I-21052 Busto Arsizio, VArese (IT)
(74) Representative: Maggioni, Claudio

(57) **Abstract**

The method described provides for the formation of thin thermal oxide on areas of a silicon die intended for memory cells and other components of the peripheral circuits of the memory. To improve the quality of the oxide of the cells essentially in terms of resistance to degradation due to the passage of charges through it during the operation of the memory, the method provides for a step for the high-temperature nitriding of the oxide. According to a variant, the nitrided oxide formed on the areas intended for the components of the peripheral circuits is removed and then formed again by a similar thermal oxidation treatment followed by high-temperature nitriding.

## Description

The present invention relates to a method of manufacturing an integrated circuit on a monocrystalline silicon die, the method providing for the formation of silicon dioxide on areas intended for components of a first type and on areas intended for components of a second type by high-temperature treatment in an oxidising atmosphere.

A typical example of an integrated circuit with components of two somewhat different types is a non-volatile memory (an EPROM, an EEPROM or a "flash" memory) with the respective control circuits, that is, the reading, writing and, in the case of "flash" memories and EEPROMs, erasing circuits.

As is known, the cells of a non-volatile memory comprise, in their structures, a "floating" gate electrode separated from the silicon surface by a dielectric. The floating gate electrode is usually constituted by a thin, doped polycrystalline element and the dielectric is a thin layer (6-35 nm) of silicon dioxide produced by oxidation of the silicon at high temperature (thermal oxide).

The control circuits of a matrix of memory cells and the other data-processing circuits, generally known as peripheral circuits, which may be integrated with the memory on the same silicon die contain components, such as MOSFET transistors and capacitors, which have structural elements similar to those of the memory cells.

In particular, the bodies of the transistors and one electrode of each capacitor of the peripheral circuits are constituted by the silicon substrate, the gate electrodes of the transistors and the other electrode of each capacitor being constituted by an electrically-conductive element of metal or doped polycrystalline silicon.

Although the components of the first type, that is, the memory cells, and the components of the second type, that is, the transistors and the capacitors of the peripheral circuits, are structurally similar, it is not always possible or convenient to produce them by exactly the same operations. In particular, the thermal oxide used as the dielectric in the memory cells and in the peripheral circuits has to have different characteristics according to the function it performs in the two types of component. In fact, whereas in the transistors and in the capacitors of the peripheral circuits maximum electrical insulation between the electrodes separated by the dielectric is of essential importance, in the cells, it is important for the oxide to be able to withstand movements of electrical charges within it, without deterioration, during the processes which occur during writing and during any erasure from the cells. Rapid degradation of the oxide in the end results in a shorter operative life of the memory.

The general purpose of the present invention is to propose a process of the type defined at the beginning which can produce dielectrics of different qualities for the two different types of component of the integrated circuit.

A particular object of the invention is to provide an integrated circuit comprising a memory and peripheral circuits in which both the memory cells and the peripheral circuits have longer operative lives than those of conventional devices.

These objects are achieved, according to the invention, by the method defined and characterized in general in the first of the claims which conclude the present description and by the integrated circuits defined in the last two claims.

The invention and the advantages resulting therefrom will be explained further by the following description of some embodiments thereof, given by way of non-limiting example.

The method according to the invention can advantageously be put into practice to produce various types of integrated circuit with memories which may even differ greatly from one another structurally. The steps which distinguish them, however, are essentially the same for any type of integrated circuit.

One embodiment of the method provides for the initial silicon wafer (which, upon completion of the method, will be divided into dies each containing an integrated circuit) to be subjected, in an initial stage of its processing, in which areas intended for the memory cells and areas intended for various components of the peripheral circuits are defined, first of all to a normal high-temperature (750-950°C) oxidation treatment in an oven at atmospheric pressure in an oxidising atmosphere (H₂O or O₂/N₂) for sufficient time to form a layer of silicon dioxide (SiO₂) on the uncovered areas of the silicon wafer and then to a nitriding treatment at a temperature which may be equal to or a little greater than the oxidation temperature (750-1050°C) in a nitrous oxide (N₂O) atmosphere at atmospheric pressure for a period of between 5 and 60 minutes to produce a dielectric of the desired thickness (6-35 nm).

The silicon dioxide layer formed by the treatment described above may be kept both on the areas intended for the memory cells and on those intended for the components of the peripheral circuits or may be removed from one or other of these areas before nitriding and reformed by a subsequent oxidation treatment. The method continues with conventional techniques until the complete integrated circuit has been formed.

It has been found that the memory cells thus formed have considerably longer lives than cells which use a layer of silicon dioxide produced in conventional manner as the dielectric.

According to a variant of the method of the invention, the silicon wafer is subjected to a first, conventional high-temperature oxidation step such as that described above until a layer of silicon dioxide of a predetermined thickness (for example, 6-35 nm) less than that (for example, 10-40 nm) desired for the peripheral components of the circuits has been produced on all of the uncovered areas of the wafer. This layer is then removed, for example, by normal chemical etching in a solution of hydrofluoric acid (HF), solely from the areas intended for the cells, so as to uncover the underlying silicon. The wafer is then subjected to a second, conventional high-temperature oxidation step and then to a nitriding treatment such as that described above until a layer of silicon dioxide of the thickness desired for the dielectrics of the cells is formed on the areas uncovered by the chemical etching.

After this second oxidation and nitriding step, the thickness of the layer of silicon dioxide on the areas intended for the other components will be increased to a certain extent and will have reached the desired thickness. Different thicknesses for the dielectrics of the cells and of the other components are thus achieved and can be determined precisely by suitable calibration of the parameters of the method during the two oxidation steps.

The methods described above produce a dielectric for the various components of the peripheral circuits which differs to a more or less marked extent from the normally-preferred dielectric which is constituted by non-nitrided silicon dioxide. In order to improve the quality of this dielectric, it was attempted to remove completely the nitrided oxide formed on the areas intended for the components of the peripheral circuits and to subject the wafer to a new oxidation treatment. It was found, predictably, that this treatment did not modify the good quality of the dielectric of the cells but also, completely unexpectedly, that it did not provide a good dielectric for the other components. The explanation for this result is still being investigated. It is clear, however, that the nitriding treatment produces undesired effects on the oxidised surface of the silicon which remain even after the layer of nitrided oxide has been removed.

According to an important variant of the method of the invention, all of the uncovered areas of the silicon wafer are first oxidised and are then nitrided as in the first embodiment described above, with a subsequent deposition of electrically-conductive material. Before the method is continued, the nitrided oxide is then removed, preferably by chemical etching, after the removal of the overlying electrically-conductive material from the areas intended for the components of the peripheral circuits, and the wafer is subjected to further oxidation by a normal treatment and to a further nitriding treatment exactly the same as the previous one. Thus not only is it possible to produce, for the components of the peripheral circuits, oxide of a different thickness from that of the cells, if required, but, surprisingly, to produce a dielectric of a quality comparable with that of simple non-nitrided thermal oxide, thus producing not only memory cells of optimal quality, but also transistors and capacitors for the peripheral circuits with characteristics practically the same as those obtainable by a conventional process. It has in fact been found that the dielectric of the peripheral circuits has a greater resistance to the "stress" due to the injection of hot electrons.

A method according to the invention for the manufacture of an integrated circuit comprising a non-volatile, programmable and erasable memory, for example, of the type known as a "flash" memory and peripheral circuits for controlling the memory will now be described briefly. The steps, carried out on a p-type monocrystalline silicon wafer are as follows:
- the formation of n-type regions (n-wells) and p-type regions (p-tubs),
- the formation of active areas insulated from one another by thick oxide (field oxide) produced by the known technique for the selective oxidation of the silicon,
- brief thermal oxidation of the active areas, followed by removal of the oxide formed to re-establish the crystalline surface characteristics of the silicon on the active areas,
- the formation of thermal oxide, followed by nitriding according to the steps described above,
- the deposition of a polycrystalline silicon layer to constitute the floating gate electrodes of the memory cells,
- the formation, on the polycrystalline silicon layer, of a dielectric, so-called "interpoly" layer, constituted by silicon dioxide alone or by a succession of layers comprising silicon dioxide and silicon nitride,
- the removal of the "interpoly" dielectric, of the polycrystalline silicon, and of the nitrided thermal oxide from the areas intended for the components of the peripheral circuits,
- the formation of thermal oxide in one or more operational steps, possibly comprising an intermediate step for the complete removal of the oxide from some of the areas intended for the components of the peripheral circuits, followed by nitriding,
- the deposition of a layer of polycrystalline silicon and a layer of metallic silicide,
- the definition of the gate structures of the memory cells and of the transistors of the peripheral circuits,
- the doping of the source and drain regions of the memory cells and of the transistors by implantation,
- the deposition of a layer of dielectric and the opening of windows therein for the contacts with doped regions and electrodes,
- the deposition of a metallic layer and the definition thereof to form the necessary circuit interconnections between the cells and the components,
- the deposition of a dielectric insulation layer and final passivation.

According to a variant of the method described above, the "interpoly" dielectric is formed by growth on the polycrystalline silicon intended for the floating gate electrodes during the "re-oxidation" step following the removal of the first thermal oxide from the areas intended for the components of the peripheral circuits.

Amongst the various integrated circuits which can advantageously be produced by the method according to the invention, it is worth mentioning, in particular, those which contain dynamic memories (DRAMs), with the respective reading/writing circuits.

In this case, the process differs from that described above essentially in that the steps for the formation of the "interpoly" dielectric are omitted and the electrically-conductive layers of material constituted by polycrystalline silicon and metallic silicide serve to form not only the gate electrodes of the transistors of the peripheral circuits, but also the gate electrodes of the memory cells.

Moreover, the method of the invention is also intended to be used advantageously for the manufacture of other MOS integrated circuits, even those which do not contain memory cells but in which there are components of different types which may benefit from the use of the two types of dielectric obtainable by the method.

Although only some embodiments of the invention have been described, clearly many variants and modifications are possible within the scope of the same inventive concept. For example, the removal of the thermal oxide may be carried out by a dry method (RIE) instead of by chemical etching in a wet solution and the nitriding could be carried out in an atmosphere containing nitrogen compounds other than nitrous oxide, for example, NO or NH₃, possibly mixed with other gases, for example Ar.

Moreover, both the thin-oxide-forming process and the nitriding process, or solely the nitriding process, could be carried out in RPT (rapid thermal process) ovens.

## Claims

1. A method of manufacturing an integrated circuit with first and second types of circuit components on a monocrystalline silicon die, which provides for the formation of silicon dioxide on areas of the die intended for components of the first type and on areas of the die intended for components of the second type by high-temperature treatment in an oxidising atmosphere and the formation of electrically conductive material on the silicon dioxide,
characterized in that it provides for a high-temperature nitriding step at least after the formation of silicon dioxide on the areas intended for the components of the first type and before the formation of electrically-conductive material on the same areas.

2. A method according to Claim 1, in which the formation of silicon dioxide comprises:
a first oxidation step comprising at least one high-temperature treatment in an oxidising atmosphere,
a step for the removal of the silicon dioxide layer formed in the previous step from the areas intended for the components of the second type, and
a second oxidation step.

3. A method according to Claim 1 in which the formation of silicon dioxide comprises:
a first oxidation step comprising at least one high-temperature treatment in an oxidising atmosphere,
a step for the removal of the silicon dioxide layer formed during the previous step from the areas intended for the components of the first type, and
a second oxidation step.

4. A method according to Claim 1 or Claim 2 in which, after the high-temperature nitriding step, it provides for:
the removal of the nitrided silicon dioxide from the areas intended for the components of the second type,
a re-oxidation step comprising at least one high-temperature treatment in an oxidising atmosphere, and
a further high-temperature nitriding step.

5. A method according to Claim 4, in which, after the re-oxidation step and before the further nitriding step, it provides for
a step for the removal of the silicon dioxide formed by the re-oxidation step from at least some predetermined areas, and
a further oxidation step.

6. A method according to Claim 4 or Claim 5,
in which the formation of electrically-conductive material comprises a step for the deposition of polycrystalline silicon before the removal of the nitrided silicon dioxide from the areas intended for the components of the second type,
in which, before the latter removal, a step is provided for the removal of the polycrystalline silicon at least from the areas intended for the same components of the second type, and
in which a step is provided for the deposition of electrically-conductive material, followed by a step for the selective removal thereof to form electrodes on the areas intended for the components of the second type.

7. A method according to Claim 6 in which a step is provided for removing the silicon dioxide grown on the polycrystalline silicon from the areas intended for the components of the first type, after the re-oxidation step.

8. A method according to Claim 7, in which the step for the selective removal of the electrically-conductive material also comprises the formation of electrodes on the areas intended for the components of the first type.

9. A method according to Claim 6 or Claim 7,
in which, between the step for the deposition of polycrystalline silicon and the step for the deposition of electrically-conductive material, it provides for the formation of at least one layer of insulating material, and
in which the step for the selective removal of the electrically-conductive material also comprises the formation of electrodes on the areas intended for the components of the first type.

10. A method according to any one of the preceding claims, in which the high-temperature nitriding is carried out in an atmosphere containing nitrous oxide (N₂O) at a temperature of between 750 and 1050°C.

11. An integrated circuit produced by the method according to any one of the preceding claims, except for Claim 8, in which the components of the first type are non-volatile memory cells.

12. An integrated circuit produced by the method according to any one of Claims 1 to 10, except for Claim 9, in which the components of the second type are dynamic RAM memory cells.
